# DEMANDE DE BREVET EUROPEEN

(11) **EP 2 402 788 A2**
(43) Date de publication de la demande: **04.01.2012**
(21) Numéro de dépôt: 11171526.4
(22) Date de dépôt: 27.06.2011
(51) Int. Cl.: G01T 1/24, H01L 31/115

(54) **Dispositif de détection de rayonnement et procédé de fabrication**

(30) Priorité: 29.06.2010 FR 1055239
(71) Demandeur: COMMISSARIAT A L'ENERGIE ATOMIQUE ET AUX ENERGIES ALTERNATIVES, 75015 Paris (FR)
(72) Inventeur: Monnet, Olivier, 38210 TULLINS (FR); Montemont, Guillaume, 38000 GRENOBLE (FR); Verger, Loïck, 38000 GRENOBLE (FR); Gentet, Marie-Claude, 38920 CROLLES (FR)
(74) Mandataire: Quantin, Bruno Marie Henri

(57) **Abrégé**

L'invention concerne un procédé de fabrication d'un dispositif de détection de rayonnements ionisants comprenant un bloc (100), dit bloc semi-conducteur, d'un matériau semi-conducteur apte à subir des séparations locales de charges entre charges positive et négative sous l'effet de radiations ionisantes ; une première série d'au moins deux électrodes (130), dites électrodes collectantes, formées à la surface du bloc semi-conducteur (100) ; une deuxième série d'au moins deux électrodes (310), dites électrodes non-collectantes, portées par un support (300) et séparées du bloc semi-conducteur (100) par une couche (500), dite couche isolante, d'un matériau diélectrique ou électriquement isolant. Le procédé est caractérisé en ce que, après avoir formé la couche isolante (500) sur le support (300) de façon à recouvrir les électrodes non-collectantes, on assemble le bloc de matériau semi-conducteur (100) portant les électrodes collectantes (130) et le support (300) portant les électrodes non-collectantes et la couche isolante.

## Description

La présente invention porte sur un dispositif de détection de rayonnements ionisants, par exemple des rayonnements gamma, à résolution spatiale, ainsi que sur un procédé de fabrication d'un tel dispositif. Le dispositif peut être utilisé dans le domaine de la sécurité, ou pour des études d'imagerie scientifique ou médicale, comme la tomographie d'émission monophotonique (TEMP).

On connaît des détecteurs utilisant un cristal semi-conducteur, par exemple de tellurure de cadmium (CdTe) ou de tellurure de cadmium-zinc (CdZnTe), au sein duquel est appliqué un champ électrique par une anode et une cathode disposées de part et d'autre du cristal.

Les rayonnements ionisants interagissant avec le cristal provoquent des séparations de charges, c'est-à-dire la formation des paires électron-trou, l'électron et le trou, initialement formés au même endroit, migrant rapidement sous l'effet du champ électrique selon des sens opposés. On peut alors collecter les électrons et/ou les trous, c'est-à-dire former un signal électrique à partir des charges circulant vers l'anode et/ou des charges circulant vers la cathode, le signal électrique ainsi mesuré reflétant l'interaction du rayonnement ionisant dans le semi-conducteur.

On précise qu'outre les rayonnements gamma, les rayons alpha, béta, X et les neutrons peuvent être détectés à l'aide de tels détecteurs à semi-conducteur.

Les détecteurs à semi-conducteur à résolution spatiale à deux dimensions connus offrent de meilleures perspectives en matière de résolution spatiale que les détecteurs, plus largement répandus, basés sur la scintillation d'un cristal ou d'un plastique en réaction à des photons, rayons X ou gamma.

Les détecteurs à semi-conducteur à résolution spatiale sont notamment susceptibles de permettre de réaliser de l'imagerie médicale, basée sur l'utilisation d'un produit radioactif émetteur de rayonnements gamma injecté au patient ou à un animal et se fixant sélectivement dans son organisme.

On connaît ainsi des détecteurs à semi-conducteur utilisant une cathode sur une face du cristal semi-conducteur, et une matrice rectangulaire de pixels formant des anodes sur l'autre face, chaque pixel définissant à la fois une coordonnée X et une coordonnée Y.

Une telle structure est qualifiée de structure « n² », n désignant le nombre de pixels anodiques alignés suivant l'un des côtés du semi-conducteur, considéré carré. Elle est complexe à mettre en oeuvre dès que la valeur de n augmente, puisqu'il est nécessaire de mettre en place des contacts et des conducteurs électriques pour extraire le signal de chaque pixel, et d'installer un grand nombre de voies de traitement des signaux.

Ainsi, cette solution devient peu praticable dès que les besoins en résolution spatiale et en surface de détection augmentent. Or, en matière médicale, la résolution spatiale souhaitée est inférieure au millimètre, et il est nécessaire de bénéficier d'un champ de vue de plusieurs centimètres carrés (par exemple 5x5 cm² pour des applications sur un petit animal). De plus, il est souhaitable que les détecteurs et l'électronique qu'ils embarquent occupent un volume compact, de manière à les rendre plus maniables dans un espace contraint, comme dans le domaine de l'imagerie médicale, où il est nécessaire de placer le détecteur au plus prés de l'organe étudié, alors que l'accès à celui-ci peut être malaisé.

Des structures permettant l'installation d'un plus petit nombre de voies électroniques tout en conservant une bonne résolution spatiale sont donc recherchées.

On connaît notamment des structures désignées sous le terme générique de structures « 2n ».

Dans le cas des semi-conducteurs pour lesquels les électrons et les trous ne migrent pas à la même vitesse, ce qui est le cas du CdZnTe ou du CdTe, ces structures comportent généralement une cathode sur une face du cristal semi-conducteur, et utilisent deux séries d'électrodes sur la face opposée, les électrodes étant étendues selon l'une ou l'autre des dimensions de la surface du cristal. La désignation « 2n » signifie alors que si l'on souhaite réaliser un imageur à n² pixels, on utilise non pas n² anodes pixellisées à la surface du matériau semi-conducteur, mais n électrodes longilignes formant une première série d'électrodes et n autres électrodes également longilignes, formant une deuxième série d'électrodes.

Les électrodes de la première série définissent la coordonnée X et sont déposées à même le matériau semi-conducteur. Il s'agit d'électrodes collectantes, car elles collectent des porteurs de charge migrant dans le détecteur. Lorsque ces derniers sont des électrons, les électrodes collectantes sont des anodes.

Les électrodes de la deuxième série sont disposées de manière transversale aux électrodes collectantes, et définissent la coordonnée Y. Ces électrodes ne sont pas en contact électrique mais en liaison capacitive avec le cristal semi-conducteur. Elles ne collectent pas de porteurs de charge, mais elles produisent un signal induit par le déplacement de porteurs de charges dans le matériau détecteur, incluant un maximum et un minimum de potentiel. On les qualifie donc d'électrodes non-collectantes.

Dans le document US6037595, un tel système « 2n » appelé « cross-strip detector » est présenté.

Les électrodes d'une première série d'électrodes sont construites par l'utilisation d'anodes ponctuelles, déposées sur le matériau semi-conducteur et reliées entre elles au sein de colonnes par des câbles conducteurs circulant à distance du matériau semi-conducteur.

Des électrodes originellement mises en place à la surface du semi-conducteur pour protéger les anodes ponctuelles vis-à-vis des effets électrostatiques induits à distance par le déplacement des électrons et des trous dans le volume de semi-conducteur sont utilisées pour former la deuxième série d'électrodes. Elles sont organisées sous forme de lignes, en étant elles aussi reliées par des câbles conducteurs circulant à distance du matériau semi-conducteur. Ces électrodes ne collectant pas les électrons mais mesurant seulement des effets induits, on les qualifie de « non-collectantes ».

Une variante décrite dans ce document utilise une couche de matériau isolant pour séparer le matériau détecteur et les électrodes non-collectantes ; cette couche de matériau isolant est déposée sur la face du détecteur. Les électrodes non-collectantes sont alors soit formées sur la couche d'isolant, soit formées sur un substrat séparé, lequel est ensuite rapporté sur la couche d'isolant.

W02008/0544862 décrit aussi un détecteur ayant une structure de type « 2n » et comprenant un volume 2 de matériau semi-conducteur, une cathode 4 sur une face de ce volume, une structure anodique 6 sur la face opposée, cette dernière comportant une première série de bandes conductrices 8 (anodes collectantes) sur la face du matériau semi-conducteur et une deuxième série de bandes conductrices 12 (anodes non-collectantes) séparées des anodes collectantes par une couche de matériau isolant 26, qui peut être AIN, Al₂O₃ ou Si₃N₄. Le matériau isolant est déposé par pulvérisation ou évaporation. La pulvérisation peut conduire à l'obtention d'une couche isolante hétérogène, parsemée de bulles d'air, et d'épaisseur inégale. L'évaporation ne se produit qu'à haute température et n'est donc pas sans risque pour le cristal semi-conducteur dont les propriétés sont généralement très sensibles à la température. Les procédés de fabrication proposés ne donnent donc pas satisfaction.

Par ailleurs, pour s'assurer que les électrons sont effectivement collectés par les anodes ponctuelles, une grille de focalisation maintenue à un potentiel intermédiaire entre les potentiels cathodiques et anodiques est parfois utilisée pour orienter les électrons. Cette grille de focalisation peut elle aussi être qualifiée d'électrode non-collectante car elle est séparée du semi-conducteur par une couche isolante et ne collecte aucun électron.

On connaît notamment, de US2002/0036269, un dispositif de détection par coïncidence comprenant au moins deux cristaux détecteurs semi-conducteurs, chaque cristal portant des anodes pixellisées sur une première face et des cathodes segmentées sur une deuxième face, chaque anode pixellisée étant reliée à une voie électronique pour la collecte de signaux représentant l'énergie des photons interagissant dans le cristal, chaque cathode segmentée étant reliée à une voie électronique pour la collecte de signaux déclencheurs de coïncidence. Dans un mode de réalisation illustré aux figures 3A et 3B de ce document, une grille de focalisation non-collectante 212 est formée entre les anodes pixellisées. Une couche isolante 210 (en forme de grille) s'étend entre la première face du cristal et la grille de focalisation. Comme indiqué [0068], le matériau isolant peut être peint, pulvérisé, déposé, assemblé par liaison chimique passivée, collée ou vaporisée sur la face du cristal. Comme précédemment expliqué, ces procédés ne donnent pas pleinement satisfaction.

Dans un autre mode de réalisation illustré à la figure 7 de US2002/0036269, le détecteur inclut comme précédemment un cristal et des anodes pixellisées. De plus, une carte à circuit imprimé portant des contacts pixellisés (612) et une grille de focalisation (616) est juxtaposée au détecteur : les contacts (612) sont collés aux anodes pixellisées (606) du détecteur à l'aide d'une colle conductrice. L'espace entre les contacts (612), les anodes (606) et la grille (616) est rempli par un matériau polymérique isolant (622) à l'état liquide à l'aide d'une mèche ([0098]). Cette couche isolante 622 est formée durant ou après l'assemblage du détecteur 602 et de la carte à circuit imprimé 610 ([0099]). Le matériau isolant porté à haute température entre alors en contact avec le détecteur, ce qui peut endommager ce dernier. En outre, l'opération d'injection du matériau isolant dans l'espace étroit destiné à le recevoir est malaisée et difficile à mettre en oeuvre de façon industrielle. Ecarter le détecteur et la carte à circuit imprimé en vue de faciliter la répartition du matériau isolant conduirait à l'obtention d'une couche isolante trop épaisse.

Dans le document Single-sided CZT Strip detectors (J. Macri et al., IEEE, Vol 51, n°5, oct 2004), au lieu d'utiliser une grille de focalisation, les électrodes non-collectantes sont elles-mêmes portées à un potentiel intermédiaire entre les potentiels cathodiques et anodiques.

Dans les deux cas, l'installation des câbles conducteurs, en dehors du plan des anodes ponctuelles, complique considérablement la fabrication, notamment quand les besoins en résolution spatiale ou surface augmentent. L'utilisation de potentiels différents pour les deux séries d'anodes ou pour la grille de focalisation constitue aussi une difficulté, car des courants de surface apparaissent dès que l'état de surface du semi-conducteur ou des autres matériaux utilisés n'est pas parfait.

De plus, un procédé de réalisation selon la variante du document US6037595 nécessite l'utilisation d'un matériau diélectrique que l'on puisse déposer à une température pouvant être supportée par le matériau semi-conducteur sur lequel est réalisé le dépôt. A défaut, le matériau semi-conducteur est déterioré. Cette condition de température est particulièrement contraignante dans le cas ou le matériau semi-conducteur comprend du CdTe ou du CdZnTe, de tels matériaux se dégradant (perte des propriétés spectro, notamment) dès que la température excède 80°C.

On connaît également du document EP1739458 un détecteur utilisant deux séries d'électrodes disposées dans deux plans distincts parallèlement à la surface du semi-conducteur, toujours du même côté de celui-ci, les électrodes étant sous forme de bandes et les deux séries d'électrodes étant séparées par un matériau électriquement isolant. L'épaisseur de celui-ci est ajustée pour obtenir un compromis entre détection du signal induit et isolation des électrodes non-collectantes.

Au cours de la fabrication d'un tel dispositif, le dépôt d'un matériau isolant sur la surface du semi-conducteur est malaisé, car à faible température, l'adhésion risque d'être insuffisante et l'épaisseur mal contrôlée, et à forte température, le semi-conducteur risque d'être endommagé.

De plus, on souhaite naturellement améliorer le rapport entre le signal mesuré par les électrodes non-collectantes et le bruit que celles-ci subissent, notamment le bruit apparaissant par effet capacitif, du fait de la collection de charges par les anodes collectantes situées à proximité.

Dans ce contexte, la présente invention vise à fournir un procédé de fabrication de détecteurs à semi-conducteur dans lequel le semi-conducteur n'est pas soumis à des températures susceptibles de dégrader ses propriétés.

L'invention vise notamment à proposer un procédé de fabrication particulièrement adapté à la fabrication de détecteurs à structures de type « 2n », qui permette d'obtenir une couche isolante (entre les électrodes collectantes et les électrodes non-collectantes) homogène, sans bulle d'air et d'épaisseur contrôlée, et ce, sans risque de dégradation du semi-conducteur. Un tel procédé est également avantageux pour la fabrication de détecteurs à structure de type « n² » (anodes pixellisées) possédant une grille de focalisation.

Ll'invention vise aussi à fournir de nouveaux détecteurs présentant des performances améliorées en termes de rapport signal sur bruit obtenu aux électrodes non-collectantes.

Un autre objectif de l'invention est de fournir un procédé de fabrication de détecteurs à semi-conducteur qui soit facile à mettre en oeuvre pour des grandes séries de dispositifs, des dispositifs à grande résolution spatiale, et des dispositifs de grande taille.

A cette fin, l'invention propose un procédé de fabrication d'un dispositif de détection de rayonnements ionisants, ledit dispositif comprenant :
- un bloc, dit bloc semi-conducteur, d'un matériau semi-conducteur apte à subir des séparations locales de charges entre charges positive et négative sous l'effet de radiations ionisantes,
- une première série d'au moins deux électrodes dites électrodes collectantes, en contact électrique avec le bloc semi-conducteur,
- une deuxième série d'au moins deux électrodes dites électrodes non-collectantes, séparées du bloc semi-conducteur par une couche, dite couche isolante, d'un matériau isolant électrique.

Le procédé selon l'invention comprend les étapes suivantes :
- on forme les électrodes collectantes sur une face du bloc semi-conducteur,
- on forme les électrodes non-collectantes sur une face d'un support.

Le procédé selon l'invention est caractérisé en ce que, après avoir formé la couche isolante sur le support de façon à recouvrir les électrodes non-collectantes, on assemble le bloc semi-conducteur portant les électrodes collectantes et le support portant les électrodes non-collectantes et la couche isolante.

Grâce à ce procédé, on peut préalablement préparer la couche isolante à haute température, avec une épaisseur, une planéité et une adhésion maîtrisées et sans risquer d'endommager le semi-conducteur puisque la couche isolante est formée uniquement sur le support et non contre le bloc semi-conducteur, ce qui permet de préserver les propriétés remarquables du matériau semi-conducteur.

Ce procédé permet ainsi aussi de choisir un matériau diélectrique sans être limité par la température maximale pouvant être supportée par le matériau semi-conducteur.

Enfin, ce procédé permet de mieux contrôler la présence de matériaux indésirables, et notamment de bulles d'air, entre les électrodes non-collectantes et le bloc semi-conducteur.

Pour toutes ces raisons, il conduit à une nette amélioration du rapport signal sur bruit obtenu aux électrodes non-collectantes.

Avantageusement, les électrodes collectantes sont linéiques ; en d'autres termes elles présentent une forme de bandes. De préférence, les bandes formant les électrodes collectantes sont déposées à la surface du bloc semi-conducteur par lithographie.

Avantageusement, les électrodes non-collectantes sont formées à la surface du support selon une méthode de fabrication de circuits imprimés. Par exemple, deux dépôts successifs sont effectués par sérigraphie.

Avantageusement et selon l'invention, la couche isolante est réalisée par dépôt du matériau isolant à l'état liquide sur le support.

L'un des apports essentiels du procédé selon l'invention est qu'il permet de choisir librement le matériau isolant. Il est dès lors possible d'utiliser un matériau diélectrique dont les caractéristiques permettent de surmonter les difficultés rencontrées avec l'expérience dans l'utilisation des structures décrites dans l'art antérieur. Notamment, les inventeurs ont découvert qu'il est avantageux que le matériau isolant électrique ait une résistivité supérieure ou égale à 10¹¹ Ω.cm, et une permittivité diélectrique relative supérieure à 5, ces gammes de valeur permettant d'obtenir des résultats excellents en termes de rapport signal sur bruit obtenu aux électrodes non-collectantes. De préférence, le matériau isolant électrique a une permittivité relative comprise entre 5 et 15, et une résistivité comprise entre 10¹¹ et 10¹² Ω.cm.

L'invention s'étend aux dispositifs pouvant être obtenus par le procédé selon l'invention et notamment à un dispositif de détection de rayonnements ionisants comportant :
- un bloc, dit bloc semi-conducteur, d'un matériau semi-conducteur apte à subir une séparation locale de charges entre charges positive et négative sous l'effet d'une radiation ionisante,
- une première série d'au moins deux électrodes dites électrodes collectantes, en contact électrique avec le bloc semi-conducteur,
- une deuxième série d'au moins deux électrodes dites électrodes non-collectantes, portées par un support et séparées du bloc semi-conducteur par une couche, dite couche isolante, d'un matériau isolant électrique,
caractérisé en ce que le matériau isolant électrique formant la couche isolante a une résistivité supérieure à 10¹¹ Ω.cm et une permittivité diélectrique relative supérieure à 5. De préférence, le matériau isolant électrique a une permittivité relative comprise entre 5 et 15, et une résistivité comprise entre 10¹¹ et 10¹² Ω.cm.

Un tel dispositif a des performances accrues en matière de résolution spatiale, le bruit subi par les électrodes non-collectantes étant particulièrement faible pour des épaisseurs de matériau rendant possible la mesure d'un signal induit exploitable. Le rapport signal mesuré par les électrodes non-collectantes sur bruit subi par ces électrodes est donc particulièrement élevé. Le dispositif est de fabrication facilitée car l'épaisseur de matériau diélectrique n'a pas besoin d'être particulièrement faible.

Le choix d'un matériau possédant de telles propriétés particulières va à l'encontre des enseignements de l'art antérieur, qui, soit enseignait d'adapter l'épaisseur du matériau à sa permittivité, soit enseignait d'utiliser une grille de focalisation pour diriger les électrons vers les électrodes collectantes, le matériau diélectrique n'étant alors qu'optionnel.

Dans certains modes de réalisation, la permittivité relative du matériau diélectrique est supérieure à 10. Avec une telle permittivité, le signal induit sur les électrodes non-collectantes est moins dépendant de variations locales d'épaisseur du matériau diélectrique, ou de la présence d'hétérogénéités entre le matériau détecteur et les électrodes non-collectantes, de telles hétérogénéités étant par exemple des bulles d'air ou des impuretés dans le matériau diélectrique.

Selon une autre définition de l'invention, le matériau isolant a de plus une résistivité supérieure à 10 fois celle du matériau semi-conducteur. Cette dernière caractéristique permet un bon couplage capacitif entre les électrodes non-collectantes et le matériau semi-conducteur.

Selon un autre aspect de l'invention, la géométrie des électrodes, et en particulier la forme des électrodes non-collectantes, satisfait certaines conditions permettant d'optimiser le rapport signal sur bruit.

L'invention consiste, selon cet aspect, en un dispositif de détection de rayonnements ionisants comportant un bloc, dit bloc semi-conducteur, d'un matériau semi-conducteur apte à subir une séparation locale de charges entre charges positive et négative sous l'effet d'une radiation ionisante, une première série d'au moins deux électrodes dites électrodes collectantes, en contact électrique avec le bloc semi-conducteur, une deuxième série d'au moins deux électrodes dites électrodes non-collectantes, portées par un support et séparées du bloc semi-conducteur par une couche, dite couche isolante, d'un matériau isolant électrique, caractérisé en ce qu'au moins une électrode non-collectante comporte au moins deux portions larges pour mesurer un signal induit par les mouvements de charge dans le bloc semi-conducteur, et en ce qu'au moins une électrode collectante s'étend en vis-à-vis d'un espace entre les deux portions larges.

Cette géométrie permet d'obtenir un angle solide par lequel l'électrode non-collectante voit le matériau semi-conducteur moins encombré par les électrodes collectantes proportionnellement à la surface de l'électrode non-collectante que dans une structure de l'art antérieur. Le bruit qui est subi par l'électrode non-collectante est diminué et le signal induit mesuré par l'électrode non-collectante est augmenté par rapport aux dispositifs antérieurs.

Si l'électrode non-collectante est fabriquées sous forme de circuit imprimé déposé sur une surface plane, alors la caractéristique précédente est mise en oeuvre en diminuant la largeur de l'électrode entre les deux portions larges, en veillent toutefois à conserver (au niveau de la portion étroite de l'électrode) une largeur suffisante pour la conduction.

Si l'électrode est fabriquée d'une autre manière, par exemple avec des liaisons filaires, la largeur de la portion étroite peut être réduite à zéro, la conduction se faisant alors dans un plan en arrière du plan des portions larges servant à la génération du signal induit, vis-à-vis du semi-conducteur.

Selon encore un autre aspect de l'invention, le dispositif de détection est caractérisé en ce qu'au moins une électrode collectante, est en forme de bande et a une largeur inférieure à celle d'une électrode non-collectante. De préférence, les électrodes collectantes présentent toutes des largeurs (identiques ou différentes) inférieures aux largeurs (identiques ou différentes) électrodes non-collectantes.

Cette géométrie des électrodes permet également d'obtenir un angle solide par lequel l'électrode non-collectante voit le matériau semi-conducteur moins encombré par les électrodes collectantes que dans une structure selon l'art antérieur. Le rapport signal produit par l'électrode non-collectante sur bruit subi par celle-ci est ainsi augmenté par rapport aux dispositifs antérieurs.

Avantageusement, le procédé selon l'invention et/ou le dispositif obtenu présentent de plus l'une ou plusieurs des caractéristiques suivantes :
- l'assemblage du bloc semi-conducteur et du support est effectué à l'aide d'une colle ;
- le support est en céramique, par exemple en alumine ;
- le matériau utilisé pour former la couche isolante est un matériau connu sous le nom ESL 4909-mod ;
- au moins un organe de connexion est agencé dans le support de façon à ce que cet organe de connexion traverse totalement le support et présente une surface de contact affleurant à la surface de la couche isolante
après formation de celle-ci et en ce que l'assemblage est effectué de façon à mettre en contact une électrode collectante et ledit organe de connexion ; l'assemblage peut être effectué en utilisant une colle conductrice disposée entre une zone de connexion de ladite électrode collectante et la surface de contact dudit organe de connexion.

L'invention va maintenant être décrite en relation avec les figures annexées.
La figure 1 est une vue de face d'un cristal semi-conducteur à l'issue d'une étape préliminaire d'un mode de réalisation du procédé selon l'invention.
La figure 2 est une vue de trois-quarts du cristal semi-conducteur de la figure 1 à l'issue de cette étape préliminaire.
La figure 3 est une vue de face d'un support à l'issue d'une autre étape préliminaire du même mode de réalisation du procédé selon l'invention.
La figure 4 est une vue de face d'un support similaire à celui présenté en figure 3, mais dans le cadre d'une variante de l'invention.
La figure 5 présente une vue de coupe d'un support similaire à ceux présentés en figures 3 et 4, à un stade ultérieur d'un procédé selon un mode de réalisation de l'invention.
La figure 6 présente le résultat d'une étape d'assemblage au cours de la mise en oeuvre d'un mode de réalisation du procédé selon l'invention.
La figure 7 présente un dispositif selon un mode de réalisation de l'invention, le semi-conducteur étant représenté transparent pour mettre en évidence les deux séries d'anodes du dispositif.
La figure 8 présente des détails du dispositif de la figure 6.
La figure 9 présente un dispositif selon un mode de réalisation de l'invention.
La figure 10 présente un signal obtenu sur une électrode non-collectante d'un dispostif selon un mode de réalisation de l'invention.
La figure 11 présente un objet de test simulant un organe humain, utilisé pour tester les dispositifs selon l'invention.
La figure 12 présente une image obtenue avec un dispositif selon un mode de réalisation de l'invention et l'objet de test de la figure 10, simulant ainsi une expérimentation médicale, avec ici, quatre détecteurs juxtaposés.

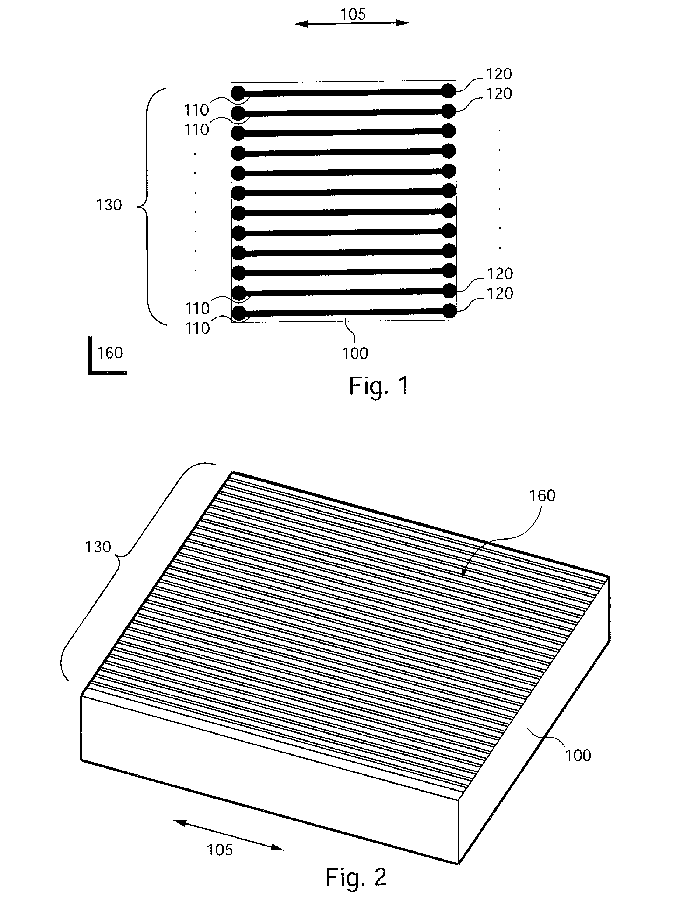

En figure 1, on a représenté un volume de cristal semi-conducteur formant un bloc semi-conducteur 100 parallélépipédique, de section carrée, représenté vu de dessus, de sorte que la figure montre la face supérieure, carrée, du bloc semi-conducteur 100. Le matériau semi-conducteur est ici du tellurure de cadmium-zinc. D'autres matériaux semi-conducteurs peuvent être utilisés. Le côté du carré est de quelques centimètres, ici 2,5 cm. Sur la face supérieure du bloc 100, sont déposées des bandes métalliques 110, à même le matériau semi-conducteur, le métal utilisé ici étant de l'or, ou selon une variante du platine. D'autres métaux conducteurs peuvent être utilisés.

En figure 1, on aperçoit douze bandes métalliques 110 s'étendant parallèlement les unes aux autres suivant une direction 105 parallèle à l'un des côtés du carré, qualifiée de première direction pour les besoins de l'exposé. Les bandes 110 sont formées directement à la surface du bloc semi-conducteur 100 sur sa face supérieure ; elles sont en contact électrique avec le matériau semi-conducteur. Elles sont donc destinées à la collecte de porteurs de charges, et seront ci-après appelées bandes ou électrodes collectantes. Lorsque ces porteurs de charges sont des électrons, cas le plus fréquent, ces bandes collectantes sont des anodes. Lorsque ces porteurs de charge sont des trous, ces bandes collectantes sont des cathodes. Dans la suite de la description, on se placera dans le cas ou ces bandes collectantes sont des anodes, le matériau détecteur étant du CdTe.

Les bandes collectantes 110 sont réparties sur l'ensemble de la surface du bloc semi-conducteur 100. Chacune d'entre elles a une largeur constante, le pas entre chaque bande, défini comme la distance séparant les axes centraux de deux bandes consécutives étant compris entre 500 µm et 1 millimètre, et dans le mode de réalisation présenté étant précisément de 750 µm. La largeur de chaque bande collectante 110 est de 150 µm, soit à peu près 1/5ème du pas. La largeur des bandes collectantes 110 est déterminée conformément à l'invention. Les bandes collectantes 110 courent sur l'ensemble de la longueur d'un côté du bloc semi-conducteur 100. Celui-ci a une épaisseur égale à 5mm.

L'ensemble des bandes collectantes 110 constitue une première série d'électrodes 130. A chacune des extrémités de chaque bande 110 est présente une zone métallique élargie 120 qualifiée de zone de connexion 120 du fait de sa fonction.

L'épaisseur des bandes collectantes 110 est de l'ordre de quelques µm et, dans le mode de réalisation présenté, est de 3 µm, lesdites bandes collectantes ayant été déposées par une technique classique de lithographie.

La face du bloc semi-conducteur portant les bandes collectantes 110 présente une surface 160 appelée première surface pour les besoins de l'exposé. L'épaisseur des bandes collectantes 110 étant faible par rapport à l'aire de la face supérieure du bloc isolant, la surface 160 formée par les bandes collectantes et par la portion de face supérieure du bloc semi-conducteur s'étendant entre lesdites bandes et est sensiblement plane.

Dans certaines variantes non représentées, les bandes collectantes 110 ont une largeur qui n'est pas constante sur toute leur longueur, et dans d'autres variantes, elles n'ont pas toutes la même largeur ou la même forme.

En figure 2, on a représenté un bloc semi-conducteur 100 similaire à celui représenté en figure 1, vu cette fois de ¾. On distingue une série 130 d'électrodes comportant cette fois-ci trente-deux électrodes collectantes (anodes) 110 de largeurs constantes. Le bloc semi-conducteur 100 a une surface frontale carrée de côté 2,5 cm. Le pas entre les anodes 110 est de 750 µm. Les zones de connexion 120 n'apparaissent pas sur la figure du fait de leur petite taille.

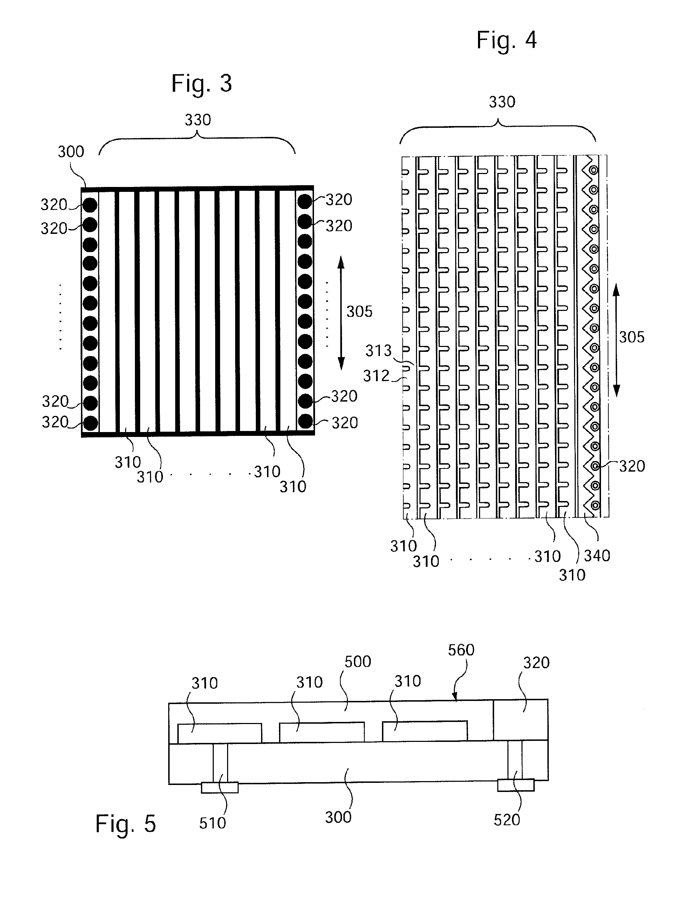

En figure 3, on a représenté un support 300 à la surface duquel sont déposées des bandes 310 métalliques: Dix bandes métalliques 310 sont ici représentées. Le matériau les constituant peut être de l'or ou du platine ou un autre métal conducteur.

Les bandes 310 s'étendent suivant une deuxième direction 305 parallèle à l'un des côtés du support 300. Dans cet exemple, La deuxième direction 305 est, au cours du procédé de fabrication, placée orthogonalement à la première direction 105. Les bandes 310 constituent une deuxième série 330 d'électrodes. Ces bandes 310 ne sont pas destinées à collecter des porteurs de charges, mais à être isolées du matériau détecteur, de façon à générer un signal induit par le déplacement des porteurs de charges dans ce matériau. Il s'agit donc d'électrodes non-collectantes. Elles sont parallèles les unes aux autres et disposées à une distance les unes des autres correspondant à un pas de 750 µm. Leur largeur est de 650 µm. La distance séparant les bords adjacents de deux bandes 310 consécutives est donc de l'ordre de 100 µm, ce qui garantit une isolation électrique entre deux bandes 310 voisines. Conformément à un aspect avantageux de l'invention, les bandes non-collectantes 310 sont plus larges que les bandes collectantes 110, et préférentiellement entre 2 et 5 fois plus larges. Dans le mode de réalisation présenté, ce rapport est de 4,3, ce qui, une fois le procédé de fabrication achevé, permet d'obtenir aux électrodes non-collectantes un rapport signal sur bruit particulièrement élevé.

Comme le bloc semi-conducteur de la figure 1, le support 300 est parallélépipédique de section carrée avec une face inférieure carrée d'environ 2,5 cm de côté, les bandes non-collectantes 310 courant sur toute la longueur d'un des côtés du carré. On note qu'en figure 3, les bandes non-collectantes 310 ont une largeur constante, mais selon des variantes, leur largeur pourrait ne pas être constante sur toute leur longueur. L'impédance des bandes est limitée.

Le support 300 est un volume de céramique, et plus précisément il s'agit ici d'alumine à 96 %. Les bandes non-collectantes 310 sont déposées par sérigraphie, leur préparation comprenant une étape de cuisson d'une pâte conductrice. Ainsi, les bandes non-collectantes 310 constituent chacune un circuit imprimé sur le support 300.

Le support 300 peut constituer un élément d'un caisson pour circuit de lecture, embarquant l'électronique nécessaire au traitement des signaux recueillis aux différentes électrodes. Le matériau le constituant a été choisi en raison de sa rigidité et de sa bonne stabilité mécanique, compatible avec des procédés de dépôt à haute température. Selon des variantes, d'autres matériaux sont utilisés (SiO₂, epoxy ou tout substrat isolant destiné à l'intégration de dispositifs électroniques).

Sur les bords de deux côtés du support 300, sont agencés des plots conducteurs 320. En figure 3, deux séries de douze plots conducteurs 320 régulièrement espacés sur les deux côtés du support 300, parallèlement aux bandes non-collectantes 310, ont été représentes.

L'épaisseur des bandes non-collectantes 310 est, dans un mode de réalisation, d'environ 10 µm. Dans un autre mode de réalisation, les bandes non-collectantes sont déposées en deux passes de 15 µm d'épaisseur résiduelle chacune, soit avec une épaisseur finale de 30 µm. Cela permet de diminuer l'impédance de chaque bande, laquelle est, dans cet exemple, de l'ordre de 2 Q.

En figure 4, on a représenté une variante d'un support tel que représenté en figure 3. Le support 300 porte une série 330 d'électrodes non-collectantes 310 parallèles les unes aux autres, mais dont la largeur n'est pas constante. Ainsi, chaque électrode non-collectante 310 comporte une succession de portions larges 312 et de portions étroites 313, suivant une forme de peigne. Cette forme de peigne est définie par une continuité de matière sur l'un des bords de la bande 310 et une forme crénelée sur l'autre bord de la bande 310. Alors que la largeur de la bande 310 est voisine de 700 µm dans les portions larges 312, elle n'est que de 150 µm au niveau des portions étroites 313.

La largeur des portions étroites 313 est adaptée en sorte d'obtenir une conduction satisfaisante sur l'ensemble de la longueur de la bande 310, d'un bord à l'autre du support 300, soit sur environ 25 mm. La distance entre deux portions larges 312 consécutives, au niveau d'une portion étroite 313 est d'environ 150 µm. On voit sur la figure dix-huit portions larges 312, mais dans un mode de réalisation préféré, chaque électrode non-collectante en comporte 32.

Sur chaque bande non-collectante 310, les portions étroites 313 sont réparties régulièrement avec un pas égal au pas avec lequel les bandes collectantes 110 sont réparties sur le volume de semi-conducteur 100 (figure 1). Les bandes non-collectantes 310 sont de plus disposées en sorte que les successions de portions étroites 313 se fassent suivant une direction perpendiculaire à la direction 305.

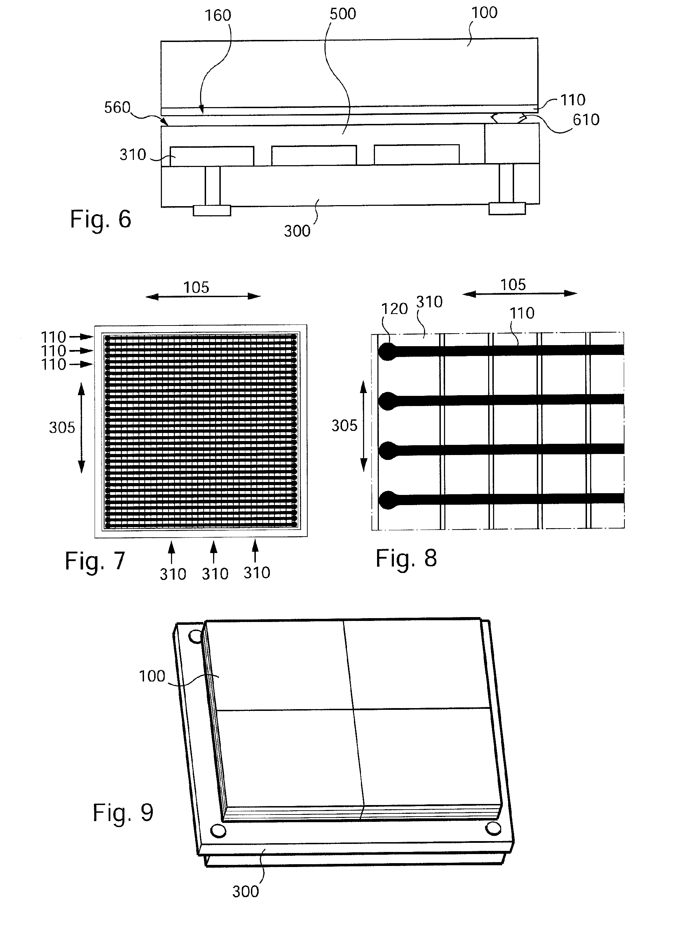

Sur un des bords du support 300, dix-huit plots conducteurs 320 sont visibles. Ils sont destinés à permettre la connexion des anodes 110, une fois le dispositif assemblé, comme on le verra en figures 6 et 8.

Une électrode 340 de fonction similaire aux électrodes non-collectantes 310 mais devant faire face à des contraintes d'isolation particulière du fait de la proximité des plots conducteurs 320 est présente entre la succession de plots conducteurs 320 et la première bande non-collectante crénelée 310. l'électrode 340 possède une géométrie en triangles successifs.

Dans le mode de réalisation présenté, on a vu que les électrodes non-collectantes sont fabriquées sous forme de circuits imprimés déposés sur une surface plane. La forme de peigne est obtenue en diminuant une largeur de l'électrode entre les deux portions larges 312, mais en conservant au niveau des portions étroites 313 une largeur suffisante pour la conduction.

Si les électrodes non-collectantes sont fabriquées d'une autre manière, par exemple avec des liaisons filaires comme présenté dans US6037595, la largeur de la portion étroite peut être réduite à zéro, la conduction se faisant alors dans un plan en arrière du plan des portions larges.

En référence à la figure 5, une fois le support 300 préparé avec la succession des bandes 310 déposées à sa surface, on procède à un dépôt d'un matériau diélectrique ou isolant électrique sur l'ensemble de la surface des bandes 310 et des espaces vides les séparant, ainsi que les créneaux correspondant aux portions étroites 313. Dans un mode de réalisation, cela est réalisé par une première étape de dépôt de matériau isolant entre les bandes 310, puis par une deuxième étape de dépôt de matériau isolant sur toute la surface du support 300.

L'épaisseur de matériau diélectrique déposé au dessus des bandes non-collectantes 310 est de l'ordre de 10 µm et est adaptée notamment pour s'assurer que l'ensemble des électrodes est effectivement recouvert. Le matériau diélectrique forme une couche isolante 500 présentant, à l'opposé du support 300 et des bandes 310, une surface 560 plane, de rugosité ne dépassant pas quelques µm. Les bandes 310 sont noyées dans cette couche isolante 500.

Le matériau diélectrique utilisé dans un mode de réalisation préféré est du ESL 4909-mod commercialisée par Electro Science Laboratories, de résistivité 10¹¹ Ω.cm et de permittivité relative ε₀ égale à 9. Le dépôt est effectué dans ce cas à 850 °C. Dans d'autres modes de réalisation, il est effectué à d'autres températures, généralement supérieures à 100°C.

Contrairement aux dispositifs de l'art antérieur, le fait de déposer un matériau isolant sur un support 300 séparé du bloc semi-conducteur 100 permet de s'affranchir de la contrainte de température imposée par celui-ci. On peut alors choisir des matériaux isolants déposés à haute température, sans risque de dégradation du matériau semi conducteur formant le bloc 100.

Un tel dépôt à température adaptée permet un contrôle de la rugosité de la surface 560 de la couche isolante, laquelle surface est destinée à être appliquée contre la face du bloc semi-conducteur portant les électrodes collectantes 110 (anodes).

La résistivité du matériau semi-conducteur étant de l'ordre de 10¹⁰ Q.cm, la résistivité du matériau diélectrique formant la couche isolante 500 lui est de préférence au moins 10 fois supérieure. Grâce à cette condition, le signal détecté par les électrodes non-collectantes 310 n'est pas perturbé par la collecte de porteurs de charges. On constate que les électrodes non-collectantes 310 sont suffisamment isolées.

Si le matériau choisi a une permittivité relative et une resistivité respectant les conditions de l'invention, le signal produit par les électrodes non-collectantes présente un rapport signal sur bruit satisfaisant. Un tel matériau permet une isolation électrique suffisante des électrodes non-collectantes 310 vis-à-vis du bloc semi-conducteur 100, tout en permettant un couplage capacitif entre ces électrodes et le semi-conducteur.

Dans des variantes, l'épaisseur de matériau diélectrique séparant les électrodes non-collectantes et les électrodes collectantes est de quelques dizaines de µm, par exemple de 2 à 50 µm.

On appréciera que, quelle que soit leur forme, les électrodes non-collectantes des exemples précédemment décrits sont, dans un plan parallèle à la surface plane 560, allongées suivant la deuxième direction 305.

En figure 5, on a également représenté une connexion traversante 510 pour l'une des bandes 310 représentée. Cette connexion 510 traverse le support 300 de part en part de manière à permettre la connexion électrique de l'électrode non-collectante 310 à une voie de lecture électronique et la mesure du signal qui est détecté par cette bande. Bien qu'elles ne soient pas représentées en dehors de celle la plus à gauche, une connexion traversante 510 est prévue pour chacune des bandes non-collectantes 310.

On a également représenté en figure 5 un organe de connexion comprenant un contact 320 et une tige conductrice 520. La tige conductrice 520 traverse le support 300 de manière à pouvoir connecter le contact 320 à des circuits de lecture pour mesurer des signaux électriques transmis par le contact 320.

Dans le mode de réalisation représenté, l'épaisseur du contact 320 est équivalente à l'épaisseur cumulée des bandes 310 et du matériau isolant déposées sur celle-ci, ce qui a pour conséquence que le contact 320 présente une surface de contact (surface supérieure sur la figure) qui est dans le prolongement de la surface 560 de la couche isolante 500. Cette surface de contact peut également être légèrement en retrait de la surface 560 (de quelques µm), le retrait pouvant ensuite être occupé par de la colle, comme on le comprendra à l'examen de la figure 6.

En figure 6, on a représenté l'assemblage du bloc semi-conducteur 100 de la figure 2 avec le support stratifié de la figure 5. Les première et deuxième directions 105 et 305 sont placées perpendiculairement l'une à l'autre et les surfaces 160 et 560 sont présentées en vis-à-vis l'une de l'autre. Dans une variante, sans être placées perpendiculairement l'une à l'autre, les première et deuxième directions sont placées transversalement l'une à l'autre.

Dans une variante où le support de la figure 4 est utilisé, les portions étroites 313 des électrodes non-collectantes sont placées à l'aplomb des bandes collectantes 110, chaque portion large 312 faisant alors face, à travers le matériau diélectrique 500 à une portion de surface du bloc semi-conducteur 100 dépourvue d'électrode collectante 110. Cela permet, une fois le procédé de fabrication achevé, d'obtenir un rapport signal sur bruit particulièrement élevé aux électrodes non-collectantes. En effet, en plaçant ainsi les zones étroites 313, on minimise le couplage capacitif entre électrode collectante et électrode non-collectante, un tel couplage étant une source de bruit affectant le signal délivré par les électrodes non-collectantes.

La vue de la figure 6 présente le support stratifié de la figure 5 sous le même angle que cette dernière figure, le bloc semi-conducteur 100 étant placé de telle sorte qu'une unique première bande 110 est visible de gauche à droite de la figure.

De la colle conductrice 610 a préalablement été posée sur la surface de contact du contact 320 et participe donc à l'immobilisation dudit contact 320 et du bloc semi-conducteur 100 lui faisant face. La surface 160 est présentée de telle sorte que chaque zone de connexion 120 fasse face à un contact 320 et la colle 610 assure donc l'immobilisation ainsi que le contact électrique de la bande collectante 110 (par sa zone de connexion) avec le contact 320. Cette épaisseur de colle sera choisie de façon à être la plus faible possible, par exemple de l'ordre de quelques µm à une dizaine de µm.

La colle 610 utilisée est dans un mode de réalisation une colle conductrice polymérisable à basse température (on entend par là polymérisable à une température inférieure à 80°C), et plus précisément la colle EG8050.

Grâce à la faible rugosité de la surface 560, on évite la présence de bulles d'air intempestives entre le bloc semi-conducteur 100 et les électrodes non-collectantes 310, de telles bulles d'air étant susceptibles d'entraîner des hétérogénéités aléatoires de la résistivité et de la permittivité de la couche isolante. On comprend alors qu'avec un tel procédé, la résistivité et la permittivité de cette couche sont mieux contrôlées.

Le détecteur est complété par une cathode unique, plane et de forme carrée positionnée contre la face inférieure du bloc semi-conducteur 100. Dans un mode de réalisation alternatif, on utilise une cathode segmentée en plusieurs cathodes élémentaires.

En figure 7, on a représenté une vue de face du détecteur tel qu'obtenu en figure 6. Pour les besoins de la figure, le bloc semi-conducteur 100 est représenté transparent de manière à faire apparaître les électrodes 110 et 310. On a représenté sur la figure les directions de ces électrodes, respectivement les directions 105 et 305.

La figure 8 présente un agrandissement de la vue de la figure 7. On reconnaît une bande collectante 110, au premier plan, perpendiculaire à une bande non-collectante 310 et de largeur nettement inférieure. On reconnaît également une zone de connexion 120 pour la récupération du signal mesuré par l'électrode collectante 110.

En figure 9, on a représenté en vue de ¾ un dispositif de détection comprenant quatre détecteurs réalisés selon l'invention et disposés jointifs les uns avec les autres sur un même support 300. Le dispositif final bénéficie donc d'une surface de détection de 5 cm de côté dans les deux directions de son plan, sans zone morte, les surfaces de détection étant jointives. La connectique relative à toutes les électrodes, qu'elles soient collectantes ou non-collectantes est placée à l'intérieur du support 300, offrant ainsi une grande compacité.

Le dispositif est mis sous tension, en appliquant une différence de potentiel entre chaque cathode et les bandes 110 qui servent d'anodes collectantes. Dans un mode préféré, la cathode est mise à un fort potentiel négatif, et les anodes collectantes sont à un potentiel commun proche de la masse.

Les bandes 310 vont servent d'électrodes non-collectantes, mesurant le signal induit par le déplacement des charges dans le bloc semi-conducteur 100. Les électrodes non-collectantes sont toutes mises à un même potentiel, qui dans un mode de réalisation est le même que celui des anodes collectantes. En variante, les anodes collectantes et les électrodes non-collectantes sont mises à des potentiels différents. En effet, le choix d'un matériau diélectrique tel que précédemment décrit rend les électrodes non-collectantes isolées électriquement à la fois du bloc semi-conducteur et des anodes collectantes.

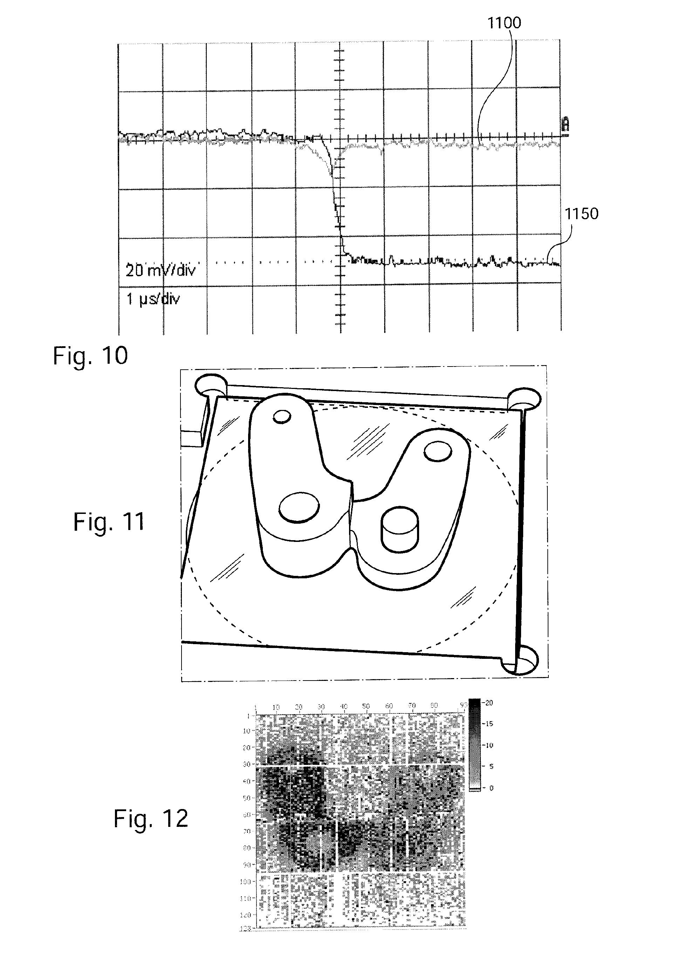

En figure 10, on a représenté sur un même graphique un signal 1100 mesuré par une électrode non-collectante et un signal 1150 mesuré par une électrode collectante (anode) du dispositif selon l'invention. L'axe des abscisses présente le temps, avec une graduation en µs, et l'axe des ordonnées présente la différence de potentiel mesurée. On constate que le potentiel de l'anode subit une chute subite d'environ 50 mV, et reste ensuite sensiblement constant, alors que le potentiel de l'électrode non-collectante subit une diminution transitoire de d'environ 16 mV, celui-ci retrouvant rapidement sa valeur initiale. La variation de potentiel de l'électrode non-collectante débute légèrement avant le début de la variation de potentiel de l'anode, comme cela est attendu pour un signal induit. Le rapport signal sur bruit observé à l'électrode non-collectante est excellent, ce qui permet l'utilisation du dispositif pour une détection à forte résolution spatiale.

En figure 11, on a représenté un dispositif de test simulant une thyroïde humaine au sein de laquelle est présent un isotope émetteur de rayons gamma, pour reproduire les conditions des expériences d'imagerie médicale.

En figure 12, on a représenté le résultat d'imagerie obtenue selon l'invention. Il est remarquable que l'on retrouve dans cette image à deux dimensions précisément la structure de la thyroïde de la figure 11 avec une résolution spatiale d'images fines, une netteté et un contraste importants.

Bien que présentée ci-dessus avec un cristal de tellurure de cadmium-zinc, l'invention peut être mise en oeuvre avec différents matériaux semi-conducteurs, comme l'arsenure de gallium GaAs, le silicium, l'iodure de mercure Hgl₂, le bromure de titane TiBr ou un autre matériau approprié, ayant de préférence une résistivité supérieure à 10⁹ Ω.cm, cela permettant que le nombre de séparations de charge apparaissant en l'absence de toute radiation ionisante reste particulièrement limité.

Par ailleurs, dans des modes de réalisation alternatifs, le matériau diélectrique 500 est un matériau connu sous le nom Dupont 5704, de permittivité relative comprise entre 8 et 10 et de résistivité proche de 10¹² Ω.cm, ou du ESL 4905C de résistivité 10¹¹ Ω.cm et de permittivité relative comprise entre 7 et 10. Un signal exploitable a été obtenu aux électrodes non-collectantes pour chacun de ces matériaux diélectriques. On rappelle que la résistivité d'un matériau détecteur de type CdZnTe est de l'ordre de 10¹⁰ voire 10¹¹ Ω.cm. Les matériaux isolants utilisés ont avantageusement une permittivité relative supérieure à 5, ou de préférence supérieure à 6, voire à 8, et inférieure à 10 ou 15, et une résistivité comprise entre 10¹¹ et 10¹² Ω.cm.

Le procédé est avantageux dans le cas ou le support et le bloc semi-conducteur sont aboutables : on peut les joindre deux à deux et constituer des dispositifs de détection de grande surface en minimisant les zones mortes, une zone morte étant une zone ne contribuant pas à la détection située à l'interface entre deux détecteurs adjacents.

L'invention ne se limite pas aux modes de réalisation décrits mais s'étend à toutes les variantes à la portée de l'homme du métier.

## Revendications

**1.** Procédé de fabrication d'un dispositif de détection de rayonnements ionisants comprenant un bloc (100), dit bloc semi-conducteur, d'un matériau semi-conducteur apte à subir des séparations locales de charges entre charges positive et négative sous l'effet de radiations ionisantes, une première série d'au moins deux électrodes (130), dites électrodes collectantes, en contact électrique avec le bloc semi-conducteur (100), une deuxième série d'au moins deux électrodes (310), dites électrodes non-collectantes, séparées du bloc semi-conducteur (100) par une couche (500), dite couche isolante, d'un matériau électriquement isolant,
le procédé comprenant les étapes suivantes :
- on forme les électrodes collectantes (130) sur une surface du bloc semi-conducteur (100),
- on forme les électrodes non-collectantes (310) sur une surface d'un support (300),
le procédé étant **caractérisé en ce que**, après avoir formé la couche isolante (500) sur le support (300) de façon à recouvrir les électrodes non-collectantes, on assemble le bloc semi-conducteur (100) portant les électrodes collectantes (130) et le support (300) portant les électrodes non-collectantes et la couche isolante.

**2.** Procédé de fabrication selon la revendication 1, **caractérisé en ce que** les électrodes collectantes (110) présentent une forme de bandes.

**3.** Procédé de fabrication selon la revendication 2, **caractérisé en ce que** les bandes formant les électrodes collectantes (110) sont déposées à la surface du bloc semi-conducteur (100) par lithographie.

**4.** Procédé de fabrication selon l'une des revendications précédentes, **caractérisé en ce que** les électrodes non-collectantes (310) sont formées à la surface du support (300) selon une méthode de fabrication de circuits imprimés.

**5.** Procédé de fabrication selon l'une des revendications précédentes, **caractérisé en ce que** la couche isolante (500) est réalisée par dépôt du matériau isolant à l'état liquide sur le support (300).

**6.** Procédé de fabrication selon l'une des revendications précédentes, **caractérisé en ce que** l'assemblage du bloc semi-conducteur et du support est effectué à l'aide d'une colle (610).

**10.** Procédé de fabrication selon l'une des revendications précédentes, **caractérisé en ce que** au moins un organe de connexion (320, 520) est agencé dans le support (300) de façon à ce que cet organe de connexion traverse totalement le support et présente une surface de contact affleurant à la surface (560) de la couche isolante (500) après formation de celle-ci et **en ce que** l'assemblage est effectué de façon à mettre en contact électrique une électrode collectante (110) et ledit organe conducteur de connexion (320).

**11.** Procédé de fabrication selon la revendication précédente, **caractérisé en ce que** l'assemblage est effectué en utilisant une colle conductrice disposée entre une zone de connexion (120) de ladite électrode collectante (110) et la surface de contact de l'organe de connexion (320).

**12.** Procédé de fabrication selon l'une des revendications précédentes, **caractérisé en ce que** le matériau utilisé pour former la couche isolante (500) a une permittivité relative comprise entre 5 et 15, et une résistivité comprise entre 10¹¹ et 10¹² Ω.cm.

**13.** Procédé de fabrication selon la revendication précédente, le matériau (500) utilisé pour former la couche isolante étant du ESL 4909-mod.

**14.** Procédé de fabrication selon l'une des revendications précédentes, **caractérisé en ce qu'**au moins une électrode collectante (110) a une largeur inférieure à celle d'une électrode non-collectante (310).

**15.** Procédé de fabrication selon l'une des revendications précédentes, **caractérisé en ce qu'**on forme au moins une électrode non-collectante (310) avec au moins deux portions élargies (312) pour mesurer un signal induit par les mouvements de charge dans le bloc semi-conducteur (100), et **en ce que** l'étape d'assemblage est effectuée en sorte de mettre en vis-à-vis une électrode collectante (110) et un espace (313) entre les deux portions élargies (312).

**16.** Procédé de fabrication selon l'une des revendications précédentes, le support (300) étant en céramique.

**17.** Procédé de fabrication selon la revendication précédente, le support (300) étant en alumine.

**18.** Dispositif de détection de rayonnements ionisants comportant :
- un bloc (100), dit bloc semi-conducteur, d'un matériau semi-conducteur apte à subir une séparation locale de charges entre charges positive et négative sous l'effet d'une radiation ionisante,
- une première série d'au moins deux électrodes (110) dites électrodes collectantes, en contact électrique avec le bloc semi-conducteur (100),
- une deuxième série d'au moins deux électrodes (310) dites électrodes non-collectantes, portées par un support (300) et séparées du bloc semi-conducteur (100) par une couche(500), dite couche isolante, d'un matériau isolant électrique,
**caractérisé en ce que** le matériau isolant électrique formant la couche isolante a une résistivité supérieure ou égale à 10¹¹ Ω.cm et une permittivité diélectrique relative supérieure à 5.

**19.** Dispositif de détection de rayonnements ionisants comportant :
- un bloc (100), dit bloc semi-conducteur, d'un matériau semi-conducteur apte à subir une séparation locale de charges entre charges positive et négative sous l'effet d'une radiation ionisante,
- une première série d'au moins deux électrodes (110) dites électrodes collectantes en contact électrique avec le bloc semi-conducteur (100),
- une deuxième série d'au moins deux électrodes (310) dites électrodes non-collectantes, portées par un support (300) et séparées du bloc semi-conducteur (100) par une couche (500), dite couche isolante, d'un matériau isolant électrique,
**caractérisé en ce qu'**au moins une électrode non-collectante (310) comporte au moins deux portions élargies (312) pour mesurer un signal induit par les mouvements de charge dans le bloc semi-conducteur (100), et **en ce qu'**au moins une électrode collectante (110) s'étend en vis-à-vis d'un espace (313) entre les deux portions élargies (312).

**20.** Dispositif de détection de rayonnements ionisants comportant :
- un bloc (100), dit bloc semi-conducteur, d'un matériau semi-conducteur apte à subir une séparation locale de charges entre charges positive et négative sous l'effet d'une radiation ionisante,
- une première série d'au moins deux électrodes (110) dites électrodes collectantes, en contact électrique avec le bloc semi-conducteur (100),
- une deuxième série d'au moins deux électrodes (310) dites électrodes non-collectantes, portées par un support (300) et séparées du bloc semi-conducteur (100) par une couche (500), dite couche isolante, d'un matériau isolant électrique,
**caractérisé en ce qu'**au moins une électrode collectante (110) a une largeur inférieure à celle d'une électrode (310) non-collectante.
